Europäisches Patentamt

European Patent Office

Office européen des brevets

(11) Publication number: **0 100 453**
**B1**

(12) **EUROPEAN PATENT SPECIFICATION**

(45) Date of publication of patent specification: **09.09.87**

(51) Int. Cl.⁴: **C 30 B 15/02, C 30 B 29/42**

(21) Application number: **83106524.8**

(22) Date of filing: **05.07.83**

(54) **Method for growing a GaAs single crystal by pulling from GaAs melt.**

(30) Priority: **08.07.82 JP 118916/82**

(43) Date of publication of application:
**15.02.84 Bulletin 84/07**

(45) Publication of the grant of the patent:
**09.09.87 Bulletin 87/37**

(84) Designated Contracting States:
**DE FR GB**

(56) References cited:
**BE-A- 666 309**
**US-A-3 507 625**
**US-A-3 615 878**
**US-A-3 902 860**

(73) Proprietor: **ZAIDAN HOJIN HANDOTAI KENKYU SHINKOKAI**
**Kawauchi 2**
**Sendai-shi Miyagi 980 (JP)**

(72) Inventor: **Nishizawa, Jun-ichi**
**6-16, Komegafukuro 1-chome**
**Sendai-shi Miyagi-ken (JP)**

(74) Representative: **Dipl.-Ing. H. Marsch Dipl.-Ing. K. Sparing Dipl.-Phys.Dr. W.H. Röhl Patentanwälte**
**Rethelstrasse 123**
**D-4000 Düsseldorf (DE)**

Courier Press, Leamington Spa, England.

## Description

The invention relates to a method of growing a GaAs single crystal in an enclosed vessel containing a batch of GaAs melt and also a GaAs single crystal whereby an As-containing chamber communicates, via a passage, with the GaAs melt vessel, comprising pulling said GaAs single crystal up from the melt and applying As vapor from the As-containing chamber to the GaAs melt and the GaAs single crystal.

Such a method is known from the US—A—3 507 625 according to which an As vapor pressure of about 0.91 Bar is applied to a GaAs melt which is present at the surface of liquid gallium due to the reaction between the liquid gallium and the As vapor. No attention is given to a relationship between the temperature of the GaAs melt and the As vapor pressure applied.

The BE—A—666 309 describes a method for growing a GaAs single crystal according to which in an open system As pressure is applied to the GaAs melt to prevent the dissociation of As from the GaAs melt. No attention is given to a relationship between the temperature of the GaAs melt and the As vapor pressure applied.

It is the object of the present invention to provide a method of growing a GaAs single crystal with a minimized deviation from stoichiometric composition.

This object is solved in holding said GaAs melt constantly at a temperature which is either the GaAs melt temperature or slightly thereabove providing a gentle temperature gradient with a continuous temperature distribution in the passage and holding said As-containing chamber at a constant temperature sufficient to insure that an optimum As vapor pressure is applied to the GaAs melt and the GaAs single crystal to provide the formed GaAs single crystal with a stoichiometric composition, the optimum As vapor pressure being given, with respect to the GaAs melt temperature, by the following formula:

$$P_{opt} \approx 3.47 \times 10^8 \exp(-1.05 \text{ eV}/kT) \text{ (Pa)},$$

wherein k represents Boltzmann constant, T the GaAs melt temperature in °K and $P_{opt}$ the optimum As vapor pressure.

This method allows to grow a GaAs single crystal of a large size having a good crystal habit due to minimized deviation from stoichiometric composition.

It is preferred to heat the GaAs melt vessel and the As-containing chamber by radio frequency heating and to provide the passage with locally ground-and-fit sealing portions of quartz or sapphire.

The invention will now be described with reference to a preferred embodiment in connection with the attached drawing.

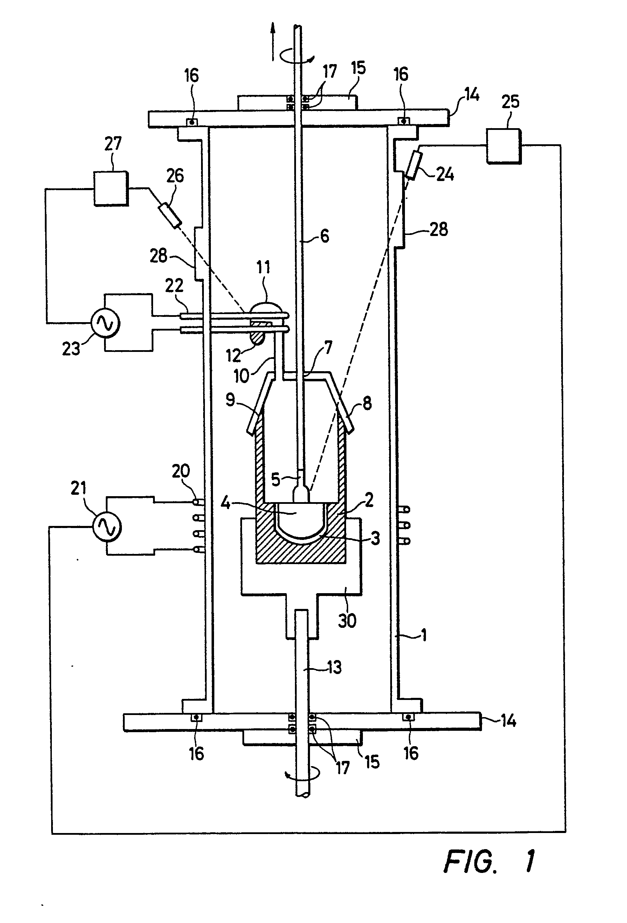

Fig. 1 is a diagrammatic illustration, partly in section, showing an apparatus for growing a GaAs single crystal according to the method of the invention.

The apparatus of Fig. 1 comprises a quartz tube 1, a GaAs melt vessel 2 made of carbon, a crucible 3 made of such material as quartz or pBN (pyrolytic boron nitride) for containing GaAs melt 4, a GaAs seed crystal 5, a pull-up rod 6 to pull up a crystal grown from a seed crystal, a ground-and-fit adjoining sealing portion 7 of the rod 6 and a cover 8 made of quartz or sapphire. The cover 8 has a ground-and-fit portion 9 established relative to the wall of the vessel 2, and into the cover 8 opens a narrow tube 10 which has a small diameter and which communicates with a chamber 11 containing As 12. A housing 30 made of such material as $Al_2O_3$ supports the vessel 2 and is connected to a rotary rod 13 intended to rotate the crucible 3. Stainless steel plates 14 and 15 support the quartz tube 1 and are provided with sealing members 16 and 17, respectively, such as O-rings or gaskets. A radio frequency induction working coil 20 for heating the vessel 2 made of carbon and accordingly the crucible 3, a power supply 21 such as a radio frequency oscillator, a radio frequency induction working coil 22 for heating the chamber 11 containing As 12 and connected to a power supply 23 such as a radio frequency oscillator, a thermometer 24 for measuring the temperature at the interface between the seed crystal 5 and the melt 4, a thermometer 26 for measuring the temperature of As 12 which is supplied into the vessel 2, temperature-adjusting members 25 and 27, respectively, for controlling the electric power of the power supplies 21 and 23, respectively, and a window 28 for observation and the measurement of temperature of the seed crystal 5, melt 4 and As 12 are provided.

The grown crystal is pulled up from the melt 4 in the following manner. The GaAs melt 4 is heated to about 1240°C which is close to the melting point of GaAs by radio frequency induction to render it to the melt state. After the temperature of the melt 4 has become constant and stable, the seed crystal 5 secured to the tip of the pull-up rod 6 is brought into contact with the melt 4. After the seed crystal 5 has effected an appropriate necking with the melt 4, the seed crystal 5 is pulled upwardly while gently rotating the rod 6, so that a single crystal is grown progressively at the tip of the seed crystal 5.

The temperature of the As chamber 11 is set constant to insure that an optimum vapor pressure $P_{opt}$ of As is supplied to the surface of the melt 4 throughout the single crystal growth process.

The optimum vapor pressure of As is approximately given by:

$$P_{opt} \approx 3.47 \times 10^8 \exp(-1.05 \text{ eV}/kT) \text{ (Pa)}.$$

Therefore, when the temperature of the GaAs is assumed to be 1240°C, its $P_{opt}$ may be regarded as being about 1.09 Bar.

The As temperature $T_{As}$ is given, if the diameter of the narrow tube 10 is small, by the following formula:

$$\sqrt{T_{As}/T_{GaAs}} = P_{As}/P_{GaAs},$$

wherein

$P_{As}$ and $T_{As}$ represent the vapor pressure and the temperature of As gas in the As chamber 11, respectively;

$T_{GaAs}$ represents the temperature of the GaAs melt; and

$P_{GaAs}$ represents the vapor pressure of As vaporizing from the GaAs melt 4, and assumes a value close to $P_{opt}$.

Accordingly, if $T_{GaAs}$ is assumed to be 1240°C, and $P_{GaAs}$ is assumed to be 1.09 Bar, it is only necessary to determine the values of $T_{As}$ and $P_{As}$ so as to be

$$\sqrt{T_{As}}/P_{As} = \sqrt{T_{GaAs}}/P_{GaAs} = 0.0474.$$

Since $P_{As}$ is determined by the value of $T_{As}$, it is only necessary to set the temperature $T_{As}$. In order to secure stoichiometric perfection of the GaAs single crystal which is grown, it is necessary to effect a strict controlling of the deviation from stoichiometry, i.e. to control the deviation at a value ±0.1°C or lower.

What is also important is the temperature gradient across the As-containing region 11 and the melt region 4. It is necessary to arrange so that this temperature gradient is gentle with a continuous temperature distribution, and to arrange especially the temperature gradient in the region close to the interface between the melt 4 and the solid state grown crystal so as to be gentle not to admit the inducement therein of any lattice dislocation. Realization of the temperature distribution of the melt region, the As region and their intermediate regions, may employ not only the RF induction heating as shown in the embodiment, but also any conventional heating method such as resistance heating. The temperature in the region leading from the carbon-made vessel 2 to the As chamber 11 desirably is arranged to be constantly higher than the temperature of the As 12 itself to avoid the deposition of As on to, for example, the quartz container 8.

The sealed site 9 between the carbon-made vessel 2 and the cover 8 made of quartz or sapphire, and the sealed site 7 between the pull-up rod 6 and said cover 8 both require to provide a ground-and-fit sealing of a high precision relative to each other to provide a good sealing therebetween so as to inhibit the leak of the vapor of As 12 applied to the crystal pull-up region defined between the wall of the carbon vessel 2 and the cover 8, as well as the leak of As vapor from the GaAs melt region, and also the leak of the As vapor from the pulled-up GaAs crystal.

In order to obtain, by the pull-up method, a GaAs single crystal having a high crystal perfection, sufficient consideration has to be given to making a precise control of the As vapor pressure which is applied, precise temperature control of not only the regions including the GaAs melt region, but also the pull-up speed, as well as the rotation speeds of the crystal and the crucible.

The controlling of the crystal which has been pulled up from the melt need only be performed while watching, through the window 28, the condition of pulling. By making a good control of the pull-up speed as well as the rotation speed of both the crystal and the crucible, it is easy to obtain a single crystal having a large diameter. In order to perform automatic controlling, it will be needless to say that a weight detector is operatively connected to the pull-up rod 6 to detect the weight of the crystal being pulled up, and to make an automatic control of the respective parameters such as the pull-up speed and the rotation speeds of the crystal as well as the crucible, all of which constitute the growth conditions.

The crucible 3 and other members of the apparatus ought to be made of sufficiently pure materials so as not to allow a dissolution of atoms of unnecessary impurities to migrate into the melt and the crystal.

In order to obtain, by the pull-up method, a GaAs single crystal having a perfect stoichiometric composition, it is necessary to make a strict control of the temperatures of the GaAs melt 4, the As chamber 11 and the passage connecting them. The heating of the crucible may be effected not only by the use of such carbon vessel as shown in the embodiment, but also by the use of, for example, a heating pipe constituted by a metal which is in the liquid condition, or by the use of both.

The vapor pressure of As for obtaining a GaAs single crystal having a good stoichiometric composition is close to the atmospheric pressure as stated above. Accordingly, in the crystal pulling-up apparatus mentioned as an embodiment, it is not very difficult to seal off the growth region. It is needless to say that, in order to prevent possible leak of As vapor to the outside of the system, the pull-up apparatus as a whole may have a pressure-resistant vessel structure. In case a pressure-resistant vessel is used, it is possible to use an inert gas such as nitrogen, argon or helium, or a mixed gas of such inert gas and As vapor, to apply a pressure into the vessel.

As stated above, the apparatus for growing a GaAs single crystal by pulling it up from a melt thereof according to the present invention enables the crystal to be pulled up while applying an optimum As vapor pressure to the GaAs melt in order to give a satisfactory stoichiometric composition of the crystal being grown. Thus, this apparatus provides a crystal having a perfect stoichiometry. Accordingly, it is possible to obtain a GaAs single crystal having a large diameter and having minimized deviation from stoichiometry and minimized lattice dislocation. Thus, the present invention has a very high industrial value.

**Claims**

1. A method of growing a GaAs single crystal in an enclosed vessel (2) containing a batch of GaAs melt (4) and also a GaAs single crystal (5) whereby an As-containing chamber (11) communicates, via a passage (10), with said GaAs melt vessel (2), comprising pulling said GaAs single crystal (5) up from said melt (4) and applying As vapor from said As-containing chamber (11) to said GaAs melt (4) and said GaAs single crystal (5), characterized in holding said GaAs melt (4) constantly at a temperature which is either the GaAs melt temperature or slightly thereabove, providing a gentle temperature gradient with a continuous temperature distribution in said passage (10) and holding said As-containing chamber (11) at a constant temperature sufficient to insure that an optimum As vapor pressure is applied to said GaAs melt (4) and said GaAs single crystal (5) to provide the formed GaAs single crystal with a stoichiometric composition, the optimum As vapor pressure being given, with respect to the GaAs melt temperature, by the following formula:

$$P_{opt} \simeq 3.47 \times 10^8 \exp(-1.05 \text{ eV/kT}) \text{ (Pa)},$$

wherein k represents Boltzmann constant, T the GaAs melt temperature in °K and $P_{opt}$ the optimum As vapor pressure.

2. The method of claim 1, characterized in that said GaAs melt vessel (2) and said As-containing chamber (11) are heated by radio frequency heating.

3. The method of claim 1 or 2, characterized in that said passage (10) has locally ground-and-fit sealing portions (9) of quartz or sapphire.

## Patentansprüche

1. Verfahren zur Herstellung von einkristallinem GaAs in einem geschlossenen Gefäß (2), das eine Charge von GaAs-Schmelze (4) und auch einen GaAs-Einkristall (5) enthält, wobei eine As enthaltende Kammer (11) über einen Durchgang (10) mit dem die GaAs-Schmelze enthaltenden Gefäß (2) in Verbindung steht, umfassend das Ziehen des GaAs-Einkristalls (5) aus der Schmelze (4) und das Einwirkenlassen von As-Dampf aus der As enthaltenden Kammer (11) auf die GaAs-Schmelze (4) und den GaAs-Einkristall (5), gekennzeichnet durch das Konstanthalten der GaAs-Schmelze (4) auf einer Temperatur, die entweder die GaAs-Schmelztemperatur oder etwas höher ist, das Vorsehen eines schwachen Temperaturgradienten mit einer kontinuierlichen Temperaturverteilung in dem Durchgang (10) und das Halten der As enthaltenden Kammer (11) auf einer konstanten Temperatur, die ausreicht um sicherzustellen, daß ein optimaler As-Dampfdruck auf die GaAs-Schmelze (4) und den GaAs-Einkristall (5) einwirkt, um den gebildeten GaAs-Einkristall mit einer stöchiometrischen Zusammensetzung zu versehen, wobei der optimale As-Dampfdruck in Bezug auf die GaAs-Schmelztemperatur durch folgende Formel gegeben ist:

$$P_{opt} \simeq 3,47 \times 10^8 \exp(-1,05 \text{ eV/kT}) \text{ (Pa)},$$

in der k die Boltzmann-Konstante, T die GaAs-Schmelztemperatur in °K und $P_{opt}$ der optimale As-Dampfdruck sind.

2. Verfahren nach Anspruch 1, dadurch gekennzeichnet, daß das die GaAs-Schmelze enthaltende Gefäß (2) und die As enthaltende Kammer (11) durch Hochfrequenz erhitzt werden.

3. Verfahren nach Anspruch 1 oder 2, dadurch gekennzeichnet, daß der Durchgang (10) lokal aufeinander geschliffene Dichtungsabschnitte (9) aus Quarz oder Saphir aufweist.

## Revendications

1. Procédé de croissance d'un cristal simple de AsGa dans un récipient fermé (2) contenant une masse de AsGa fondu (4) et également un cristal simple de AsGa (5) de telle sorte qu'une chambre (11) contenant du As communique par un conduit (10) avec ledit récipient du AsGa fondu (2), consistant à tirer ledit cristal simple de AsGa (5) dudit AsGa fondu (4) et à appliquer de la vapeur de As venant de ladite chambre (11) contenant le As sur ledit AsGa fondu (4) et ledit cristal simple de AsGa (5), caractérisé par le fait qu'il consiste à maintenir constamment ledit AsGa fondu (4) à une température qui est celle de la fusion du AsGa, ou légèrement supérieure, à réaliser dans ledit conduit (10) un faible gradient de température par une distribution continue de cette température, et à maintenir ladite chambre (11) contenant du As à une température constante suffisante pour assurer qu'une pression optimum de vapeur de As soit appliquée audit AsGa fondu (4) et audit cristal simple de AsGa (5), pour donner au cristal simple de AsGa une composition stoechiométrique, la pression optimum de vapeur de As étant obtenue en fonction de la température du AsGa fondu selon la formule suivante:

$$P_{opt} \simeq 3,47 \times 10^8 \exp(-1,05 \text{ eV/kT}) \text{ Pa}$$

dans laquelle k représente la constante de Boltzmann, T la température en degrés Kelvin du AsGa fondu et $P_{opt}$ la pression optimum de la vapeur de As.

2. Procédé selon la revendication 1, caractérisé par le fait que ledit récipient contenant le AsGa fondu (2) et ladite chambre (11) contenant le As sont chauffés par ondes de fréquence radio.

3. Procédé selon l'une des revendications 1 et 2, caractérisé par le fait que ledit conduit (10) comporte des passages d'étanchéité en quartz ou saphir posés et scellés sur place.

0 100 453

FIG. 1